# FASCICULE DE BREVET EUROPEEN

(11) **EP 1 201 007 B1**
(45) Date de publication et mention de la délivrance du brevet: **21.05.2003**
(21) Numéro de dépôt: 00949641.5
(22) Date de dépôt: 05.07.2000
(51) Int. Cl.: H01Q 1/22, G06K 19/077, B64F 5/00

(54) **ANTENNE POUR CARTES A PUCE SANS CONTACT, CARTES HYBRIDES ET ETIQUETTES ELECTRONIQUES**
ANTENNE FÜR KONTAKTLOSE CHIPKARTE, HYBRIDKARTEN UND ELEKTRONISCHE ETIKETTEN
ANTENNA FOR CONTACTLESS CARDS, HYBRID CARDS AND ELECTRONIC LABELS

(30) Priorité: 08.07.1999 FR 9909059
(43) Date de publication de la demande: 02.05.2002
(73) Titulaire: Gemplus, 13881 Gémenos Cedex (FR)
(72) Inventeur: MARTIN, David, F-13600 La Ciotat (FR); ODDOU, Laurent, F-13600 La Ciotat (FR); ZAFRANY, Michael, F-13006 Marseille (FR)
(74) Mandataire: Scheer, Luc
(86) Numéro de dépôt international: FR0001930
(87) Numéro de publication internationale: WO01004988

(56) Documents cités:
- EP-A- 0 708 414
- EP-A- 0 908 843
- WO-A-98/04105
- FR-A- 2 743 649
- US-A- 5 598 032

## Description

La présente invention concerne le domaine des dispositifs portables tels que les cartes à circuit intégré sans contact et les étiquettes électroniques (ou tags) sans contact. Elle concerne plus particulièrement une antenne améliorée pour de tels dispositifs.

Les cartes sans contact sont par exemple destinées à la réalisation d'opérations bancaires, de communications téléphoniques, d' identification, de débit ou de rechargement d'unités de compte. Ces opérations s'effectuent grâce à un couplage électromagnétique à distance, en principe de type 'inductif, entre le microcircuit intégré dans la carte et un appareil récepteur ou lecteur, lorsque la carte se trouve dans la zone d'action de celui-ci. Le couplage peut être réalisé en mode lecture seule ou en mode lecture/écriture.

On englobe ici dans le concept de carte sans contact également les cartes dites hybrides, c'est-à-dire les cartes à microcircuit intégré pouvant fonctionner aussi bien selon le mode avec contact que selon le mode sans contact.

Ces cartes hybrides sont destinées, par exemple, à des opérations de type "télébillétique", dans lesquelles les cartes sont d'abord chargées en unités de valeur et sont ensuite, lors de chaque transaction, débitées à distance d'un certain nombre de ces unités de valeur lorsqu'elles passent à proximité d'une borne de lecture. Les cartes peuvent ensuite être rechargées dans un distributeur approprié.

Il est souhaitable que les cartes sans contact aient des dimensions identiques aux dimensions normalisées des cartes à puce classiques avec contacts. C'est même indispensable pour les cartes hybrides, puisqu'elles sont assimilables pour partie à des cartes avec contacts. Or celles-ci sont conformées selon la norme ISO 7810, définissant une carte de 85 mm de longueur, 54 mm de largeur et 0,76 mm d'épaisseur.

Quant aux étiquettes électroniques, elles sont généralement utilisées dans des opérations d'identification ou de suivi. Elles sont composées d'une part d'un module à microcircuit électronique et d'autre part d'un support de ce module associé à une antenne bobinée ou imprimée fonctionnant à fréquence relativement basse (en pratique 150 KHz) et ayant des dimensions relativement grandes par rapport à celles du module électronique.

Dans les cartes sans contact, les cartes hybrides et/ou les étiquettes électroniques, un support électriquement isolant perte au moins un enroulement servant d'antenne pour le transfert d'information par effet inductif produit par un champ électromagnétique approprié et un circuit intégré relié électriquement aux extrémités dudit enroulement. Ce support a une épaisseur très faible, ce qui constitue une contrainte majeure, puisque dans les types de supports considérés l'antenne doit être intégrée ou incorporée dans l'épaisseur du dit support.

Structurellement, une antenne classique pour carte à puce sans contact, carte à puce hybrides ou étiquette électronique comporte un conducteur disposé en spirale autour d'un point central. Cette spirale de conducteur est appelée piste. L'espace entre deux spires de conducteur consécutives est appelé espace interpistes. La section transversale d'une telle piste a généralement une géométrie rectangulaire, trapézoïdale ou circulaire.

Un facteur qualité d'antenne élevé est indispensable au moins dans les applications dans lesquelles des performances maximales de portée du produit sans contact doivent être atteintes.

Pour atteindre un tel facteur qualité, l'antenne doit présenter une résistance électrique minimale pour le nombre de tours retenu pour l'enroulement d'antenne. Cette résistance minimale peut être obtenue par:
- emploi d'un matériau d'antenne à faible résistivité électrique,
- utilisation d'un conducteur de forte section, donc des pistes larges et/ou aussi épaisses que possible.

Une possibilité consiste donc à utiliser un matériau d'antenne moins résistif. Cependant, chaque technologie de fabrication de telles antennes emploie un matériau bien déterminé et l'emploi d'un matériau moins résistif ne peut alors se faire que si l'on change de technologie. Au surplus, la résistivité d'un tel matériau ne peut être abaissée en dessous d'une limite inférieure que l'homme du métier peut déterminer dans chaque cas d'espèce.

Du fait de ces limites, et également lorsque le matériau d'antenne est imposé, seules la largeur et/ou l'épaisseur des pistes peuvent être ajustées. Mais pour certaines technologies de fabrication de telles antennes, notamment la gravure de cuivre, une configuration d'antenne correspondant à des pistes larges, en pratique d'une largeur supérieure à 0,35 mm, entraîne un bombé du substrat plastique fin dans lequel est incorporée l'antenne. Ce bombé peut atteindre plusieurs millimètres pour une antenne à pistes de 1,2 mm.

Le bombé est notamment dû à des contraintes apparaissant à l'interface antenne/substrat qui ne peuvent pas se libérer en raison d'une grande surface de contact entre le métal d'antenne et le substrat de celle-ci. Cette situation peut se produire notamment dans le cas où la piste d'antenne est réalisée par gravure chimique de métal laminé sur une feuille support.

De plus, le bombé de l'ensemble se retrouve partiellement sur la carte à puce ou l'étiquette électronique, une fois que le processus de fabrication de ce support est achevé.

En outre, cet accroissement de la largeur et/ou de l'épaisseur des pistes d'antenne augmente le coût matière des dispositifs concernés. En outre, chacune des technologies utilisables pour la réalisation de telles pistes d'antenne comporte une limite maximale pour l'épaisseur du matériau d'antenne.

L'invention a pour but de procurer une antenne pour cartes à circuit intégré et/ou pour étiquettes électroniques permettant d'atteindre un facteur élevé de qualité sans bombé marqué sur le support d'antenne.

On propose pour cela une antenne pour dispositif portable tel que carte à circuit intégré et/ou étiquette électronique dans laquelle les pistes d'antenne des cartes à circuit intégré sans contact, des cartes à circuit intégré hybrides et/ou des étiquettes électroniques sont divisées longitudinalement en pistes multiples, de préférence en pistes multiples ayant une largeur de piste unitaire inférieure à 1,2 mm. En pratique, cette largeur unitaire des pistes multiples est inférieure, et de préférence significativement inférieure, à 350 µm (soit 0,35 mm) environ, qui représente la valeur de la largeur habituelle des pistes de telles antennes selon la technique antérieure.

Avec le dispositif selon l'invention, on peut obtenir des propriétés électriques sensiblement préservées, ou même pratiquement identiques, par rapport à celles des antennes de cartes à circuit intégré sans contact, de cartes hybrides et/ou d'étiquettes électroniques obtenues conformément aux techniques connues avec une seule piste dont la largeur de piste est supérieure à celle des conducteurs utilisés selon la présente invention.

Avantageusement la somme des largeurs unitaires des pistes multiples susdites est comprise entre 125 et 800 µm environ, tandis que le nombre de sous-pistes peut varier ad libitum, de préférence entre 2 et 5.

En variante, ces pistes unitaires peuvent être reliées entre elles, de préférence par des ponts de matière conductrice qui est avant ageusement la même matière que celle des pistes de l'antenne, en des points répartis, régulièrement ou non, le long de la spire d'antenne. Selon cette variante, les pistes multiples ou sous-pistes reliées entre elles forment un réseau s'apparentant à une piste massive classique de même largeur que le total des largeurs unitaires des sous-pistes.

La largeur cumulée, donc la section cumulée pour une hauteur égale, de tous les conducteurs formant ces sous-pistes selon l'invention peut être égale à celle de la piste simple selon la technique antérieure.

L'invention a également pour objet un procédé pour la fabrication d'antennes pour dispositifs portables tels que carte à circuit intégré sans contact, carte hybride et/ou étiquette électronique, dans lequel on réalise une telle antenne sous la forme de plusieurs sous-pistes parallèles ou sensiblement parallèles, et éventuellement reliées entre elles par des ponts de matière conductrice en des points répartis, régulièrement ou non, le long de la spirale d'antenne.

Les modes de fabrication d'une telle antenne sont semblables à ceux utilisés pour les antennes à piste unique connues de la technique antérieure. En particulier, des techniques de fabrication sont décrites dans le document FR-A 2 743 64.9 au nom de la même demanderesse.

A titre d'exemple non limitatif, on peut cïter la gravure de Cu ou Al, la sérigraphie et la technologie MID ( abréviation de "Moulded Interconnexion Devices"), qui peut être employée pour le dépôt des spires de fil sur un substrat présentant un relief, tandis que les connexions électriques entre les contacts du circuit intégré et les extrémités de l'enroulement de l'antenne peuvent être réalisées par des techniques classiques.

Le document FR-A-2743649 evoque plus haut, décrit un module électronique sans contact. Ce module est destine à être connecté à une antenne disposée dans sa totalité sur le module. La Piste d'antenne est enroulée dassiquement en spires et ne comporte pas de pistes multiples ou sous-pistes.

Le document EP-A-0708414 décrit un support de données sans contact, comportant une puce dans un boîtier. Ce boîtier est inséré dans un ensemble de deux feuilles centrales superposées pour former un dispositif portable à circuit intégré. Ce support de données est propose en alternative aux dispositifs dans lesquels la puce est insérée de façon non symétrique. L'objectif est de rendre le dispositif moins sensible aux sollicitations mécaniques. En ce qui concerne l'antenne, il n'est question que d'une piste d'antenne, en spirale (voir Figures 4 et 5.)

Le document WO-A-9804105 décrit la fabrication de circuits imprimés à partir d'un film diélectrique revêtu d'une couche conductrice. Un usinage mécanique approprie de cette couche effectue une découpe, par exemple, en une piste conductrice en spirale (voir Figures. 8, 9 et 10.) La largeur de la découpe est minimale et corrélativement les pistes conductrices 8 ont une larguer maximale (voir page 9 lignes 27-30.)

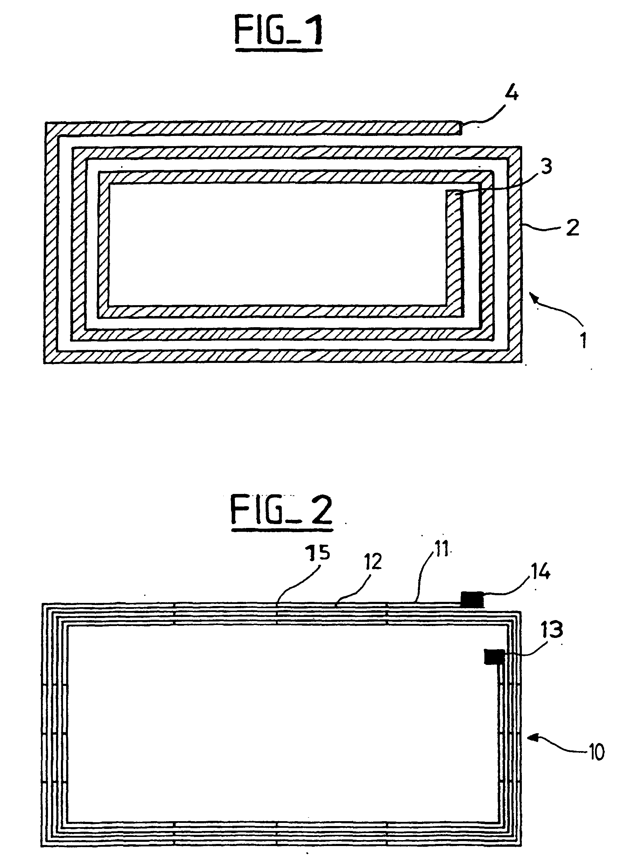

Le document EP-A-0908843 décrit une carte électronique sans contacts, comportant un enroulement en spirale servant d'antenne inductrice l'enroulement conducteur 4 en spires est composé d'un conducteur unique ayant deux extrémités 7,8 (voir figures. 1 et 2, et colonne 4, lignes 43-54).

Le document US-A-5598032 décrit une carte à puce hybride présentant des contacts d'antenne situés dans une cavité pour module électronique. Pour satisfaire à des exigences d'épaisseur maximale et de positionnement du module, une couche du corps de carte est contre moulée sur l'antenne positionnée sur une première couche du corps. Une cavité est formée ou réservée pour dégager les contacts d'extrémité de l'antenne et permettre l'insertion du module. L'antenne est constituée par une piste en spirale ou encore par des enroulements en spirale indépendants sur des couches distinctes de matériau.

L' invention a en outre pour objet un dispositif portable de type carte à circuit intégré sans contact, carte à circuit intégré hybride ou étiquette électronique, contenant au moins une antenne comportant des pistes multiples selon la présente invention.

Ces pistes multiples ou sous-pistes fines se sont avérées engendrer peu de contraintes à l'interface matériau d'antenne/substrat plastique, et ainsi éviter un bombé important au-dessus du dit substrat, tout en procurant une réduction significative de l'effet de peau normalement constaté dans le matériau conducteur d'antenne.

L'invention est décrite plus concrètement en référence aux dessins annexés, dans lesquels:
Fig. 1 représente schématiquement, en vue de dessus , une antenne pour carte à circuit intégré selon la technique antérieure,
Fig. 2 représente schématiquement, en vue de dessus, une antenne selon la présente invention.

La piste unique 2 d'une antenne 1 selon la technique antérieure est raccordée à ses deux extrémités 3,4 respectivement à chacun des plots de sortie d'un microcircuit intégré (non représenté) , éventuellement par l'intermédiaire de pistes conductrices ou de plages de connexion. Cette antenne est un simple fil 2, qui forme une inductance permettant un couplage électromagnétique de type inductif, à distance appropriée d'un appareil produisant un tel champ électromagnétique.

Le fil d'antenne peut être gainé ou non avec un matériau isolant, sauf à ses extrémités 3,4, qui doivent pouvoir être en contact électriquement conducteur avec les plots du microcircuit intégré.

Selon l'invention (voir Fig. 2), la spirale de matériau d'antenne 10 est divisée en deux sous-pistes parallèles 11,12, dont chacune est raccordée par ses extrémités 13 et 14 respectivement aux plots de contact du microcircuit intégré destiné à être noyé dans le corps de carte ou d'étiquette électronique (non représenté).

Avantageusement les sous-pistes 11,12 sont reliées entre elles par des ponts 15 répartis le long de la spirale d'antenne. Les ponts 15 ont pour fonction de répartir la densité de courant et d'assurer la continuité de la spire si l'une des sous-pistes vient à être rompue.

Les cartes et étiquettes munies d'une ou plusieurs antennes selon l'invention comportent en outre les composants classiques pour de tels dispositifs portables, notamment un corps de carte ou d'étiquette, des matériaux de métallisation et/ou de fixation, ainsi que des fils et/ou des pistes de connexion, et éventuellement des plages de contact et autres.

Les principaux avantages que procurent le produit et le procédé selon l'invention sont:
- possibilité de fabriquer des antennes ayant un facteur qualité élevé tout en conservant un substrat plastique plat et non bombé pour le dispositif portable où elles sont noyées,
- réduction de l'effet de peau dans les conducteurs de l'antenne.

## Revendications

1. Antenne pour dispositif portable tel que carte à circuit intégré et / ou étiquette électronique, **caractérisée en ce que** la piste d'antenne (10) est divisée longitudinalement en pistes multiples ou sous-pistes (11,12) au moins au nombre de deux.

2. Antenne selon la revendication 1, **caractérisée en ce que** la largeur unitaire des pistes multiples est inférieure à 1,2 mm.

3. Antenne selon la revendication 2, **caractérisée en ce que** la largeur unitaire des pistes multiples est inférieure à 35 µm environ.

4. Antenne selon l'une des revendications 1 à 3, **caractérisée en ce que** la somme des largeurs unitaires des pistes multiples est comprise entre environ 125 et 800 µm environ, le nombre de pistes étant compris entre 2 et 5.

5. Antenne selon l'une des revendications 1 à 4, **caractérisée en ce que** les pistes unitaires sont reliées entre elles par des ponts (15) de matière conductrice, en des points répartis le long de la spire d'antenne.

6. Antenne selon l'une des revendications 1 à 5, **caractérisée en ce que** la piste d'antenne est réalisée par gravure chimique de métal laminé sur une feuille support.

7. Procédé pour la fabrication d'antennes pour dispositif portable tel que carte à circuit intégré sans contact et/ou étiquette électronique, dans lequel on réalise une antenne sous la forme de plusieurs sous-pistes parallèles ou sensiblement parallèles (11,12), et éventuellement reliées entre elles par des ponts de matière conductrice (15) en des points répartis le long de la spirale d'antenne (10).

8. Dispositif portable tel que carte à circuit intégré sans contact, carte à circuit intégré hybride et étiquette électronique, **caractérisé en ce qu'**il comporte au moins une antenne (10) selon l'une des revendications 1 à 6.

## Patentansprüche

1. Antenne für eine tragbare Vorrichtung wie beispielsweise eine IC-Karte und/oder ein elektronisches Etikett, **dadurch gekennzeichnet, dass** die Antennenspur (10) in Längsrichtung in Mehrfachspuren oder in mindestens zwei Unterspuren (11, 12) unterteilt ist.

2. Antenne nach Anspruch 1, **dadurch gekennzeichnet, dass** die Einzelbreite der Mehrfachspuren kleiner ist als 1,2 mm.

3. Antenne nach Anspruch 2, **dadurch gekennzeichnet, dass** die Einzelbreite der Mehrfachspuren kleiner ist als etwa 35 µm.

4. Antenne nach einem der Ansprüche 1 bis 3, **dadurch gekennzeichnet, dass** die Summe der Einzelbreiten der Mehrfachspuren zwischen etwa 125 und etwa 800 µm beträgt, wobei die Anzahl der Spuren zwischen 2 und 5 liegt.

5. Antenne nach einem der Ansprüche 1 bis 4, **dadurch gekennzeichnet, dass** die Einzelspuren durch an über die Länge der Antennenwindung verteilte Brücken (15) aus leitendem Material miteinander verbunden sind.

6. Antenne nach einem der Ansprüche 1 bis 5, **dadurch gekennzeichnet, dass** die Antennenspur per chemischer Gravur von auf einer Trägerfolie laminiertem Metall hergestellt ist.

7. Herstellungsverfahren von Antennen für die tragbare Vorrichtung wie beispielsweise eine kontaktlose IC-Karte und/oder ein elektronisches Etiketts, bei dem man eine Antenne in Form von mehreren parallelen oder etwa parallelen Unterspuren (11,12) herstellt, die eventuell durch an über die Länge der Antennenspirale (10) verteilte Brücken aus leitendem Material (15) miteinander verbunden sind.

8. Tragbare Vorrichtung wie beispielsweise eine kontaktlose IC-Karte, eine hybride IC-Karte oder ein elektronisches Etikett, **dadurch gekennzeichnet, dass** sie mindestens eine Antenne (10) nach einem der Ansprüche 1 bis 6 aufweist.

## Claims

1. An antenna for a portable device such as an integrated circuit card and/or an electronic label, **characterised in that** the antenna track (10) is divided longitudinally into multiple tracks or subtracks (11, 12) at least two in number.

2. An antenna according to Claim 1, **characterised in that** the unitary width of the multiple tracks is less than 1.2 mm.

3. An antenna according to Claim 2, **characterised in that** the unitary width of the multiple tracks is less than approximately 35 Nm.

4. An antenna according to one of Claims 1 to 3, **characterised in that** the sum of the unitary widths of the multiple tracks is between approximately 125 and approximately 800 µm, the number of tracks being between 2 and 5.

5. An antenna according to one of Claims 1 to 4, **characterised in that** the unitary tracks are connected together by bridges (15) of conductive material, at points distributed along the antenna turn.

6. An antenna according to one of Claims 1 to 5, **characterised in that** the antenna track is produced by chemical etching of metal laminated on a support sheet.

7. A method for the manufacture of antennae for a portable device such as a contactless integrated circuit card and/or an electronic label, in which an antenna is produced in the form of several parallel or substantially parallel subtracks (11, 12) possibly connected together by bridges of conductive material (15) at points distributed along the antenna spiral (10).

8. A portable device such as a contactless integrated circuit card, a hybrid integrated circuit card and an electronic label, **characterised in that** it comprises at least one antenna (10) according to one of Claims 1 to 6.
